# EUROPÄISCHE PATENTSCHRIFT

(11) **EP 4 270 020 B1**
(45) Veröffentlichungstag und Bekanntmachung des Hinweises auf die Patenterteilung: **30.07.2025**
(21) Anmeldenummer: 22170194.9
(22) Anmeldetag: 27.04.2022
(51) Int. Cl.: G01R 23/20, G01R 31/00

(54) **INTERMODULATIONS-MESSVERFAHREN, INTERMODULATIONS-MESSVORRICHTUNG UND COMPUTERPROGRAMM ZUR ERMITTLUNG EINER INTERMODULATIONSQUELLE IN EINER ÜBERTRAGUNGSSTRECKE**
INTERMODULATION MEASURING METHOD, INTERMODULATION MEASURING DEVICE, AND COMPUTER PROGRAM FOR DETERMINING AN INTERMODULATION SOURCE IN A TRANSMISSION LINE
PROCÉDÉ DE MESURE D'INTERMODULATION; DISPOSITIF DE MESURE D'INTERMODULATION ET PROGRAMME INFORMATIQUE DESTINÉ À LA DÉTERMINATION D'UNE SOURCE D'INTERMODULATION DANS UN TRAJET DE TRANSMISSION

(43) Veröffentlichungstag der Anmeldung: 01.11.2023
(73) Patentinhaber: Rosenberger Hochfrequenztechnik GmbH & Co. KG, 83413 Fridolfing (DE)
(72) Erfinder: Kaindl, Benjamin, 83413 Fridolfing (DE)
(74) Vertreter: Lorenz, Matthias

(56) Entgegenhaltungen:
- WO-A1-2021/217214
- DE-A1- 102015 212 278
- US-A1- 2013 182 753
- US-A1- 2016 316 422
- ANONYMOUS: "Application Note, IMD Measurements Using Dual Source and Multiple Source Control, MS4640B Series Vector Network Analyzer", 27 May 2015 (2015-05-27), XP055689658, Retrieved from the Internet <URL:https://dl.cdn-anritsu.com/en-us/test-measurement/files/Application-Notes/Application-Note/11410-00816C.pdf> [retrieved on 20200428]

## Beschreibung

Die Erfindung betrifft ein Intermodulations-Messverfahren zur Ermittlung einer Intermodulationsquelle mittels Intermodulationsmessung in einer Übertragungsstrecke, insbesondere zur Ermittlung einer passiven Intermodulationsquelle in einer Mobilfunk-Übertragungsstrecke, gemäß dem Oberbegriff des Anspruchs 1.

Die Erfindung betrifft außerdem ein Computerprogramm zur Ausführung des Verfahrens.

Die Erfindung betrifft ferner eine Intermodulations-Messvorrichtung zur Ermittlung einer Intermodulationsquelle mittels Intermodulationsmessung in einer Übertragungsstrecke, insbesondere zur Ermittlung einer passiven Intermodulationsquelle in einer Mobilfunk-Übertragungsstrecke, aufweisend einen Testsignalgenerator und eine Messeinrichtung, gemäß dem Oberbegriff des Anspruchs 14.

Als Intermodulation (IM) wird die Entstehung von Frequenzen (nachfolgend "Intermodulationsfrequenzen") durch nichtlineare Überlagerung zweier oder mehrerer Signalfrequenzen in einer Übertragungsstrecke bezeichnet. Intermodulationen treten unter anderem in Übertragungsstrecken der Nachrichtentechnik auf und sind in der Regel unerwünscht. Grundsätzlich können beliebige nichtlineare Bauteile oder Komponenten derartige Intermodulationsquellen darstellen.

Häufig sind vor allem passive Intermodulationsquellen in einer Übertragungsstrecke problematisch. Wird ein hochfrequentes Übertragungssignal über eine Übertragungsstrecke (z. B. über eine Übertragungsstrecke mit einer Antenne, einem Steckverbinder, einem Kabel, einem Filter etc.) übertragen, so werden an nichtlinearen Übertragungsstellen bzw. Übertragungsgliedern Oberwellen oder Intermodulationsprodukte erzeugt, die sich als Störsignalanteile dem Nutzsignal überlagern. Der Einfluss dieser so genannten passiven Intermodulation (PIM) ist insbesondere in der Mobilfunktechnik von zunehmender Relevanz. Passive Intermodulationsquellen können beispielsweise auf mechanische Instabilitäten der Antennen, Steckverbinder, Kabel und Filter zurückzuführen sein (z. B. "Wackelkontakte"). PIM-Signale werden vor allem von Steckverbindungen und HF-Signalkabeln innerhalb einer Mobilfunkübertragungsstrecke erzeugt. Fehlerhafte Abschlusswiderstände, korrodierte Steckverbinder, schlechte Lötstellen oder lockere Schraubverbindungen auf Grund mangelhaft durchgeführter Montage, Witterungsbedingungen und/oder Alterung der Bauteile sind die relevantesten passiven Intermodulationsquellen.

Auch unzureichend oder fehlerhaft entworfene Komponenten einer Übertragungsstrecke können eine (passive) Intermodulationsquelle darstellen.

Die passive Intermodulation führt schließlich zu einem erhöhten Grundrauschen und mindert damit letztendlich die Leistung und Qualität des Mobilfunks. Unerkannte Intermodulationsquellen können sich zu einem massiven Störfaktor im Mobilfunkbetrieb entwickeln, da sich die Effekte insbesondere beim Datenverkehr mit hohen Datenraten bemerkbar machen.

Problematisch an der Überlagerung eines HF-Nutzsignals mit einem PIM-Signal ist die Tatsache, dass aufgrund der Nichtlinearität der Intermodulationsquelle das zeitliche Auftreten und der Signalpegel des PIM-Signals stochastisch schwanken können. Eine Kompensation der nichtlinearen PIM-Störung im Übertragungssignal mittels üblicher Entzerrungsverfahren liefert daher typischerweise keine guten Ergebnisse.

Vor diesem Hintergrund ist es aus der Praxis bekannt, mittels einer Intermodulationsmessung das Auftreten von Intermodulationsquellen zu ermitteln und deren Auswirkung in der Übertragungsstrecke auf Zulässigkeit zu bewerten. Ist der Einfluss der Intermodulationsquelle zu groß, sollte die Intermodulationsquelle beseitigt werden. Im Rahmen der Intermodulationsmessung wird daher zunächst festgestellt, ob eine relevante Intermodulationsquelle in der Übertragungsstrecke vorhanden ist. Anschließend kann die Intermodulationsquelle gegebenenfalls identifiziert bzw. in der Übertragungsstrecke geortet und bestenfalls beseitigt oder deren Einfluss auf ein akzeptables Maß reduziert werden.

Zur Ermittlung der Intermodulationsquellen wird die Übertragungsstrecke in der Regel mit zwei HF-Trägern bzw. Testsignalen mit jeweils unterschiedlicher Testsignalfrequenz (nachfolgend f₁, f₂) beaufschlagt und die Existenz und der Pegel einer potentiellen Intermodulationsquelle über eine Pegelmessung des reflektierten Intermodulationsprodukts bei einer bestimmten Intermodulationsfrequenz ermittelt. Dabei kann der Zusammenhang *f_{IM} =* ± *m* · *f*₁ ± *n · f*₂ zur Bestimmung der Intermodulationsprodukte f_{IM} der jeweiligen Ordnung (m+n) herangezogen werden. Der erfasste Signalpegel kann anschließend durch Vergleich mit einem Schwellenwert auf einen zulässigen Wert geprüft werden.

Die Erkennung der Intermodulationsquellen kann allerdings nicht in allen Fällen unter kontrollierten Laborbedingungen stattfinden, sondern erfolgt regelmäßig im Einflussbereich von potentiellen Störquellen (z. B. Mobiltelefone) und mitunter sogar "im Feld" bzw. am vorgesehenen Einsatzort der Übertragungsstrecke, d. h. beispielsweise auf einem Mobilfunkmast. Dem gemessenen Ausgangssignal der Intermodulationsmessung sind daher üblicherweise verschiedene Störungen überlagert, die das Ergebnis der Messung verfälschen können. Mögliche Störquellen sind beispielsweise (stochastisches) Rauschen, Interferenzen von mehreren Intermodulationsquellen und eine Verzerrung des PIM-Signals. Das wesentliche Problem ist allerdings in realen (Mobil)funksignalen zu sehen, die naturgemäß im Frequenzbereich der Intermodulationsmessung liegen können. Mobilfunksignale sind hinsichtlich ihrer Zeitdauer, ihres Leistungs- bzw. Signalpegels und ihrer Bandbreite abhängig vom verwendeten Mobilfunkstandard sowie dem aktuell herrschenden Mobilfunkverkehr und daher während der Intermodulationsmessung nicht vorhersagbar - und bei Messungen im Feld auch nicht vermeidbar, insbesondere wenn die Antenne nicht aus der zu untersuchenden Übertragungsstrecke entfernt werden kann oder darf.

Die Störungen bzw. Überlagerungen können daher die Intermodulationsmessung beeinträchtigen und zu einer falsch erkannten Intermodulationsquelle führen. Die Fehler- bzw. Intermodulationsquellensuche gestaltet sich daher als außerordentlich aufwendig und ist mitunter nicht zuverlässig möglich.

Zum weiteren technischen Hintergrund sei noch auf die folgenden Druckschriften verwiesen:
Anonymous, "Application Note, IMD Measurements Using Dual Source and Multiple Source Control, MS4640B Series Vector Network Analyzer", (20150527), URL: https://dl.cdn-an-ritsu.com/en-us/test-measurement/files/Application-Notes/Application-Note/11410-00816C.pdf betrifft eine Applikationsbeschreibung eines Netzwerkanalysators zur Intermodulationsmessung, bei dem zwei Testsignale simultan in die Übertragungsstrecke eingespeist werden, wonach das Ausgangssignal analysiert wird.

Die WO 2021/217214 A1 betrifft ein Verfahren zur Identifizierung von PIM-Quellen für eine zu testende Antenne, die in einer gewünschten Betriebsumgebung installiert ist. Das System umfasst einen PIM-Analysator und einen tragbaren HF-Sender, der so konfiguriert ist, dass er ein drittes HF-Stimulationssignal an vermutete externe PIM-Quellen anlegt.

Die US 2013/182753 A1 betrifft eine Vorrichtung zur Lokalisierung von passiven Intermodulationsfehlern in einem Koaxialkabelnetz.

Die DE 10 2015 212 278 A1 betrifft ein Verfahren zur Intermodulationsanalyse eines Empfangssignals mit den Schritten: Empfangen des Empfangssignals, das in Basisbandsignale, von vorgegebenen relevanten Ursprungsfrequenzen heruntergemischt wird, Berechnen von Kreuzkorrelationen zwischen den erzeugten Basisbandsignalen und einem in dem Empfangssignal aufgetretenen störenden Intermodulationsprodukt und Ermitteln mindestens einer Ursprungsfrequenz eines Störsignals, welches das störende Intermodulationsprodukt in dem Empfangssignal verursacht, anhand der berechneten Kreuzkorrelationen.

Die US 2016/316422 A1 betrifft Systeme und Verfahren zur Analyse von Hochfrequenzdaten, wobei die HF-Daten von einem oder mehreren HF-Sensoren empfangen werden, und wobei die HF-Daten über einen bestimmten Frequenzbereich und eine bestimmte Auflösungsbandbreite gesammelt werden.

In Anbetracht des bekannten Stands der Technik besteht die Aufgabe der vorliegenden Erfindung darin, ein Intermodulations-Messverfahren bereitzustellen, das eine zuverlässige Ermittlung von Intermodulationsquellen in einer Übertragungsstrecke ermöglicht, bei vorzugsweise guter Unterscheidbarkeit von sonstigen Störungen oder Überlagerungen in der Übertragungsstrecke.

Der vorliegenden Erfindung liegt auch die Aufgabe zugrunde ein Computerprogramm zur Ausführung eines verbesserten Intermodulations-Messverfahrens bereitzustellen, das eine zuverlässige Ermittlung von Intermodulationsquellen in einer Übertragungsstrecke ermöglicht.

Außerdem ist es Aufgabe der Erfindung, eine Intermodulations-Messvorrichtung bereitzustellen, die eine zuverlässige Ermittlung von Intermodulationsquellen in einer Übertragungsstrecke ermöglicht, bei vorzugsweise guter Unterscheidbarkeit von sonstigen Störungen oder Überlagerungen in der Übertragungsstrecke.

Die Aufgabe wird für das Intermodulations-Messverfahren mit den in Anspruch 1 aufgeführten Merkmalen gelöst. Hinsichtlich des Computerprogramms wird die Aufgabe durch die Merkmale des Anspruchs 13 und betreffend die Intermodulations-Messvorrichtung durch Anspruch 14 gelöst.

Die abhängigen Ansprüche und die nachfolgend beschriebenen Merkmale betreffen vorteilhafte Ausführungsformen und Varianten der Erfindung.

Es ist ein Intermodulations-Messverfahren vorgesehen, zur Ermittlung einer Intermodulationsquelle mittels Intermodulationsmessung in einer Übertragungsstrecke, insbesondere zur Ermittlung einer passiven Intermodulationsquelle in einer Mobilfunk-Übertragungsstrecke.

Im Rahmen der erfindungsgemäßen Ermittlung der Intermodulationsquelle ist insbesondere festzustellen, ob eine Intermodulationsquelle bzw. eine für die Übertragungsstrecke relevante Intermodulationsquelle vorhanden ist oder nicht vorhanden ist. Unter der erfindungsgemäßen Ermittlung der Intermodulationsquelle kann aber grundsätzlich auch (alternativ oder ergänzend) die Identifizierung bzw. Ortung der Intermodulationsquelle verstanden werden.

Besonders eignet sich das vorgeschlagene Verfahren zur Ermittlung einer passiven Intermodulationsquelle in einer Übertragungsstrecke, insbesondere in einer Mobilfunk-Übertragungsstrecke. Die Erfindung kann sich aber zur Ermittlung einer beliebigen Intermodulationsquelle eignen, beispielsweise also auch zur Ermittlung einer Intermodulationsquelle, die auf ein aktives elektronischen Bauelement zurückzuführen ist, beispielsweise auf ein fehlerhaftes nichtlineares Bauelement, das außerhalb der vorgesehenen Spezifikationen arbeitet.

Das erfindungsgemäße Verfahren umfasst zumindest die Verfahrensschritte:
- Einspeisen (insbesondere simultanes bzw. gleichzeitiges Einspeisen) eines ersten Testsignals und eines zweiten Testsignals in die Übertragungsstrecke, und
- Messen eines Ausgangssignals der Übertragungsstrecke als Reaktion auf die eingespeisten Testsignale.

Es kann insbesondere vorgesehen sein, zwei Testsignale mit einer für eine gute Erkennbarkeit im Rahmen der Messung ausreichend hohen Leistung auf definierten Testfrequenzen in die zu prüfende Leitung bzw. Übertragungsstrecke einzuspeisen. Insofern besagte Testsignale auf die nichtlineare Intermodulationsquelle treffen, kommt es zu einer Vermischung, bei der Intermodulationsfrequenzen erzeugt werden. Durch die Messung des Ausgangssignals kann der Intermodulationssignalpegel (insbesondere Amplitude bzw. Signalspannung oder Signalleistung) des dabei entstehenden PIM-Signals erfasst werden. Wenn also während des Messvorgangs bei den Intermodulationsfrequenzen Signalpegel über einem bestimmten Schwellenwert erfasst werden, kann der Messtechniker vorzugsweise Maßnahmen zur genauen Ortung der Intermodulationsquelle und zur Problembehebung einleiten.

Grundsätzlich kann eine beliebige Anzahl Testsignale in die Übertragungsstrecke eingespeist werden. In der Regel ist die Verwendung von genau zwei Testsignalen (die vorliegend als "erstes Testsignal" und "zweites Testsignal" bezeichnet werden) zur Ermittlung einer Intermodulationsquelle allerdings ausreichend. Zur Erzeugung der Testsignale kann der nachfolgend noch genannte Testsignalgenerator vorgesehen sein.

Die Messung des Ausgangssignals kann durch die nachfolgend noch genannte Messeinrichtung erfolgen. Die Messung des Ausgangssignals erfolgt vorzugsweise im Zeitbereich über einen definierten Zeitraum, vorzugsweise über denselben Zeitraum, in dem die Testsignale eingespeist werden.

Eine Schwierigkeit der Intermodulationsmessung ist regelmäßig in der exakten Lokalisation der Intermodulationsquelle zu sehen. Es kann daher optional vorgesehen sein, der Übertragungsstrecke während des Einspeisens der Testsignale bzw. während des Messens des Ausgangssignals einen mechanischen Stimulus zuzuführen (z. B. Klopfen oder Biegen von elektronischen Komponenten und HF-Verbindungsstellen). Insofern dann die mechanisch stimulierte elektronische Komponente oder Verbindungsstelle einen übermäßig hohen PIM-Pegel erzeugt, der ohne die Stimulation nicht messbar ist, wurde die jeweilige Intermodulationsquelle erfolgreich identifiziert und kann ersetzt oder repariert werden. Auf diese Weise kann sichergestellt werden, dass die HF-Infrastruktur der Übertragungsstrecke im Betrieb belastbar und ordnungsgemäß betreibbar ist, selbst wenn diese extremen Witterungsverhältnissen ausgesetzt ist.

Erfindungsgemäß ist vorgesehen, dass das gemessene Ausgangssignal in einem diskreten Frequenzspektrum analysiert wird, um den Intermodulationssignalpegel an einer diskreten Intermodulationsfrequenz zu bestimmen.

Unter einem "Signalpegel", beispielsweise dem vorstehend genannten "Intermodulationssignalpegel", kann im Rahmen der vorliegenden Erfindung insbesondere ein Spektralwert verstanden werden, aus dem der Betrag oder das Quadrat (Leistung) ermittelt wurde (ggf. ist aber auch eine Darstellung als Vektor, also Betrag und Phase, möglich). Insbesondere kann es sich bei dem "Signalpegel" um einen Leistungspegel handeln. Grundsätzlich ist aber auch ein Signalpegel im Zeitbereich im Rahmen der Erfindung möglich (insbesondere eine Amplitude, wie eine Signalspannung).

Die Analyse des Ausgangssignals kann insbesondere mittels der nachfolgend noch genannten Steuereinrichtung erfolgen, die aus den zeitlichen Messsignalen des Ausgangssignals zunächst das diskrete Frequenzspektrum berechnet und anschließend an der erwarteten bzw. zu analysierenden Intermodulationsfrequenz den Signalpegel bzw. den Intermodulationssignalpegel erfasst.

Vorzugsweise wird die vorstehend genannte Analyse des Frequenzspektrums während der Intermodulationsmessung bzw. während dem Einspeisen der Testsignale, teilweise während der Intermodulationsmessung bzw. teilweise während dem Einspeisen der Testsignale oder nach der Intermodulationsmessung bzw. nach dem Einspeisen der Testsignale durchgeführt. Eine Analyse des Frequenzspektrum noch vor dem Einspeisen der Testsignale ist im Rahmen der Erfindung in der Regel nicht vorgesehen, allerdings optional als Ergänzung ebenfalls möglich, beispielsweise um vor der eigentlichen Intermodulationsmessung- und Analyse die aktiven Signalfrequenzen im zu untersuchenden Messfrequenzbereich zu sichten.

Vorzugsweise erfolgt die vorstehend genannte Analyse im Frequenzspektrum automatisiert oder zumindest teilautomatisiert, unter Verwendung besagter Steuereinrichtung.

Erfindungsgemäß ist vorgesehen, dass der Messfrequenzbereich des Frequenzspektrums so festgelegt wird, dass das Frequenzspektrum zumindest den Signalpegel einer weiteren diskreten Messfrequenz aufweist.

Vorzugsweise ist das Frequenzspektrum so festgelegt, dass das Frequenzspektrum zumindest die Signalpegel zweier weiterer diskreter Messfrequenzen aufweist, die die Intermodulationsfrequenz umgeben.

Anstatt einer im Stand der Technik angewendeten reinen Pegelmessung bei der zu messenden Intermodulationsfrequenz, bei der also einzig der PIM-Signalpegel ausgewertet wird, wird vorliegend eine Spektralanalyse vorgeschlagen, bei der die Betrachtung der zu der Intermodulationsfrequenz benachbarten Leistungsdichte vorgesehen ist. Dadurch kann die Genauigkeit bei der Erfassung des Intermodulationssignalpegels erhöht sein. Ferner können optional Rückschlusse auf die Plausibilität der Messung möglich sein.

Neben der diskreten Intermodulationsfrequenz erstreckt sich das vorgeschlagene Frequenzspektrum somit auf zumindest eine, vorzugsweise zumindest zwei weitere Messfrequenzen. Vorzugsweise sind allerdings mehr als zwei weitere diskrete Messfrequenzen neben der Intermodulationsfrequenz vorgesehen, vorzugsweise mehr als zehn, mehr als zwanzig, mehr als fünfzig, mehr als hundert oder noch mehr diskrete Messfrequenzen. Grundsätzlich ist eine hohe Anzahl weiterer diskreter Messfrequenzen neben der Intermodulationsfrequenz für eine Erhöhung der Genauigkeit und zur Prüfung der Plausibilität der Intermodulationsmessung vorteilhaft. Bei Erhöhung der Anzahl Messfrequenzen erhöht sich allerdings auch der rechnerische Aufwand bei der Erzeugung des Frequenzspektrums, weshalb der Fachmann - je nach Anwendung - vorzugsweise zwischen Genauigkeit und Rechenaufwand abwägen sollte.

Dadurch, dass die Analyse bzw. Ermittlung der Intermodulationsquelle im Frequenzbereich bzw. im diskreten Frequenzspektrum erfolgt und neben der Intermodulationsfrequenz noch weitere diskrete Messfrequenzen in dem Frequenzspektrum enthalten sind, verteilen sich Störungen der Übertragungsstrecke, die sich nicht unmittelbar an der Intermodulationsfrequenz wiederfinden, auf die weiteren Messfrequenzen bzw. fallen nicht zu einem gemeinsamen, vermeintlichen Intermodulationssignalpegel zusammen. Durch das vorgeschlagene Verfahren kann sich die Wahrscheinlichkeit, an der zu erwartenden bzw. zu untersuchenden Intermodulationsfrequenz tatsächlich nur Signalanteile der Intermodulation zu erhalten, wesentlich erhöhen.

Die Gefahr, eine Intermodulationsquelle zu erkennen, die tatsächlich nicht vorhanden ist oder die für die Übertragungsstrecke nicht relevant ist, sondern nur auf sonstige Störungen, beispielsweise Einkopplungen von Mobilfunksignalen, zurückzuführen ist, wird erfindungsgemäß deutlich reduziert.

Die Erfindung eignet sich daher besonders vorteilhaft für Intermodulationsmessungen, bei denen sich Störquellen, wie Mobilfunksignale, nicht ausschließen lassen können, wie dies beispielsweise bei Messungen im Feld der Fall sein kann.

In einer vorteilhaften Ausgestaltung der Erfindung kann vorgesehen sein, dass das erste Testsignal mit einer konstanten, ersten Testsignalfrequenz in die Übertragungsstrecke eingespeist wird. Die Testsignalfrequenz des ersten Testsignals kann gegebenenfalls aber auch variieren (z. B. als "Upsweep", "Downsweep", oder gewobbelte Frequenz). In der Regel ist allerdings eine konstante erste Testsignalfrequenz bevorzugt.

Es kann vorgesehen sein, dass das zweite Testsignal mit einer konstanten oder variierenden (z. B. als "Upsweep", "Downsweep" oder gewobbelte Frequenz), zweiten Testsignalfrequenz in die Übertragungsstrecke eingespeist wird.

Vorzugsweise unterscheiden sich die Testsignalfrequenzen der Testsignale. In der Regel ist es bevorzugt, wenn die erste Testsignalfrequenz und die zweite Testsignalfrequenz jeweils konstant sind.

Es kann optional auch vorgesehen sein, dass die Leistungen des ersten Testsignals und/oder des zweiten Testsignals variiert werden. Vorzugsweise ist die jeweilige Testsignalleistung allerdings konstant.

In einer Ausgestaltung der Erfindung kann vorgesehen sein, dass das erste Testsignal und/oder das zweite Testsignal zeitlich konstante Signale sind (CW-Signale). Vorzugsweise handelt es sich bei dem ersten Testsignal und/oder bei dem zweiten Testsignal um ein schmalbandiges Signal, vorzugsweise um ein sinusförmiges Signal. Grundsätzlich kann allerdings eine beliebige Wellenform vorgesehen sein.

In einer Ausgestaltung der Erfindung kann außerdem vorgesehen sein, dass mehrere einzelne Intermodulationsmessung sequentiell nacheinander durchgeführt werden, beispielsweise mit jeweils konstanten Testsignalfrequenzen.

Gemäß einer Ausgestaltung der Erfindung kann vorgesehen sein, dass eine schnelle Fourier-Transformation ("Fast Fourier Transform", FFT) zur Berechnung des diskreten Frequenzspektrums verwendet wird.

Bei der schnellen Fourier-Transformation handelt es sich um einen effizienten Algorithmus zur Berechnung der diskreten Fourier-Transformation bzw. zur Berechnung des diskreten Frequenzspektrums, weshalb sich eine schnelle Fourier-Transformation vorliegend besonders gut eignen kann. Grundsätzlich kann das diskrete Frequenzspektrum allerdings auch auf andere Weise berechnet werden.

Gemäß einer Weiterbildung der Erfindung kann vorgesehen sein, dass die Auflösungsbandbreite (RBW) des diskreten Frequenzspektrum 100 Hz bis 10 kHz beträgt.

Vorzugsweise beträgt die Auflösungsbandbreite 500 Hz bis 5 kHz, besonders bevorzugt etwa 1 kHz.

In einer Weiterbildung der Erfindung kann vorgesehen sein, dass der in dem diskreten Frequenzspektrum analysierte Messfrequenzbereich 10 kHz bis 100 kHz beträgt, vorzugsweise 20 kHz bis 80 kHz, besonders bevorzugt 30 kHz bis 50 kHz, ganz besonders bevorzugt etwa 40 kHz.

Interferenzen von externen Störquellen sind hauptsächlich auf Mobilfunkgeräte zurückzuführen, da diese nahezu ungehindert in die Übertragungsstrecke eingespeist werden können (z. B. durch mangelhafte Schirmwirkung der HF-Leitungen / HF-Bauteile bei Mobilfunkgeräten in direkter Umgebung, insbesondere aber auch durch die für den Empfang der Mobilfunksignale vorgesehene Antenne, wenn diese nicht aus der Übertragungsstrecke entfernt werden kann). Daher ist es vorteilhaft, die Frequenzbereiche der relevanten Mobilfunkstandards zumindest teilweise in das Frequenzspektrum einzubeziehen. Insbesondere kann vorgesehen sein, dass der analysierte Messfrequenzbereich wenigstens einen Trägerfrequenzabstand ("Subcarrier") eines Mobilfunkstandards mit umfasst. Gegebenenfalls kann sogar vorgesehen sein, dass der analysierte Messfrequenzbereich zumindest der Nutzbandbreite eines Mobilfunkstandards entspricht. Der Messfrequenzbereich kann sich vorzugsweise aus der Intermodulationsfrequenz als Mittenfrequenz ergeben, zuzüglich einer beidseitigen Bandbreite von mindestens einem Frequenzträgerabstand des für die Übertragungsstrecke relevanten Mobilfunkstandards. Auf diese Weise lässt sich im Messfrequenzbereich jedes relevante Mobilfunksignal einfangen und in die Auswertung einbeziehen, um eine Falscherkennung einer Intermodulationsquelle bestmöglich auszuschließen.

Mögliche zu berücksichtigende Mobilfunkstandards können beispielsweise den Normen 2G, 3G, 4G oder 5G als GMSK, CDMA oder OFDM mit ca. 200 kHz bis 4 MHz kontinuierlichem Spektrum oder (derzeit) 15 kHz Subcarrier-Spacing entsprechen.

In einer Weiterbildung der Erfindung kann vorgesehen sein, dass der Intermodulationssignalpegel der Intermodulationsfrequenz dritter Ordnung bestimmt wird.

Es hat sich herausgestellt, dass insbesondere das Intermodulationsprodukt der dritten Ordnung störend sein kann, da die entsprechende Intermodulationsfrequenz in die Bandbreite des auf dem Trägersignal modulierten Datensignals (insbesondere Mobilfunksignals) fallen kann.

Die Intermodulationsfrequenz dritter Ordnung kann vorzugsweise durch Subtraktion der Testsignalfrequenz des zweiten Testsignals von der doppelten Testsignalfrequenz des ersten Testsignals ermittelt werden. Grundsätzlich kann für die Berechnung der Intermodulationsfrequenz der bereits zuvor erwähnte Zusammenhang *f_{IM} =* ± *m* · *f*₁ ± *n · f*₂ für die Ordnung (n+m) gelten, bei konstanten Testsignalfrequenzen f₁, f₂.

In einer vorteilhaften Weiterbildung der Erfindung kann vorgesehen sein, dass die diskrete Intermodulationsfrequenz die Mittenfrequenz zwischen den weiteren diskreten Messfrequenzen in dem diskreten Frequenzspektrum bildet.

Grundsätzlich kann die Intermodulationsfrequenz in dem diskreten Frequenzspektrum aber auch außermittig versetzt sein, beispielsweise wenn sich zu erwartende und von der Intermodulationsquelle zu unterscheidende Störungen in der Übertragungsstrecke vermehrt im niederfrequenten oder hochfrequenten Bereich auswirken. In der Regel ist es allerdings sinnvoll, die Intermodulationsfrequenz als Mittenfrequenz zu wählen.

Erfindungsgemäß ist vorgesehen, eine Plausibilitätskontrolle der Intermodulationsmessung mittels einer eigens hierfür eingerichteten Steuereinrichtung durchzuführen (beispielsweise mittels der nachfolgend noch genannten Steuereinrichtung) um auszuwerten, ob der in dem diskreten Frequenzspektrum erfasste Intermodulationssignalpegel mit ausreichender Plausibilität auf eine Intermodulationsquelle in der Übertragungsstrecke zurückzuführen ist anstatt auf eine sonstige Störung oder Einkopplung in der Übertragungsstrecke.

Es kann also ermittelt werden, ob die Intermodulationsmessung ein aussagefähiges Messergebnis liefert oder nicht. Die Intermodulationsmessung kann schließlich in Abhängigkeit der Plausibilität verworfen, wiederholt oder zur Ermittlung der Intermodulationsquelle herangezogen werden.

Eine zu verwerfende Messung kann beispielsweise von einer automatisierten Weiterverarbeitung ausgeschlossen werden und/oder durch Interaktion, beispielsweise durch optische bzw. bildliche oder sonstige Darstellung der Messung, einem Techniker als nicht ausreichend plausibel bzw. fehlerhaft angezeigt werden. Entsprechend kann die Messung gegebenenfalls automatisiert wiederholt oder ein Techniker angewiesen werden, die Messung zu wiederholen.

Auf vorteilhafte Weise können dadurch "falschen Fehler" bzw. falsch erkannte Intermodulationsquellen, die tatsächlich nicht vorhanden sind oder nicht in der erfassten Intensität vorhanden sind, von der weiteren Berücksichtigung ausgeschlossen werden. Eine umständliche bzw. unnötige Suche nach der vermeintlichen (sporadischen) Intermodulationsquelle kann daher vermieden werden.

Es kann vorgesehen sein, im Rahmen der Plausibilitätskontrolle einen Plausibilitätskennwert zu ermitteln, um die Plausibilität der Intermodulationsmessung zu quantifizieren. Der Plausibilitätskennwert kann vorzugsweise mit der jeweiligen Intermodulationsmessung, beispielsweise dem erfassten Intermodulationssignalpegel, verknüpft werden. Aufgrund des ermittelten Plausibilitätskennwerts kann beispielsweise entschieden werden, ob die Intermodulationsmessung verworfen, wiederholt oder als gültig angesehen wird. Diese Entscheidung kann grundsätzlich auch einem Techniker überlassen werden, der die Intermodulationsmessung durchführt, beispielsweise indem dem Techniker der Plausibilitätskennwert zusammen mit dem Ergebnis der Intermodulationsmessung angezeigt wird.

Die Plausibilität der Intermodulationsmessung, beispielsweise der Hinweis, eine Messung auszuschließen oder zu wiederholen, gegebenenfalls auch eine Darstellung des vorstehend genannten Plausibilitätskennwertes, kann im Rahmen einer herkömmlichen PIM-Auswertung angezeigt werden (z. B. Kennzeichnung im Frequenz-Sweep-Mode, im Time-Sweep-Mode und/oder im Spektrogramm-Sweep-Mode).

In einer vorteilhaften Weiterbildung der Erfindung kann vorgesehen sein, dass für die Plausibilitätskontrolle die Signalpegel einiger oder aller Messfrequenzen im diskreten Frequenzspektrum mit dem Intermodulationssignalpegel verglichen werden.

Die Plausibilität der Intermodulationsmessung steigt vorzugsweise mit der Differenz zwischen dem Intermodulationssignalpegel und dem größten Signalpegel der für die Plausibilitätskontrolle herangezogenen Messfrequenzen.

Unter der Differenz zwischen dem Intermodulationssignalpegel und einem Signalpegel ist im Rahmen der Erfindung das Resultat der Subtraktion des Signalpegels von dem Intermodulationssignalpegel zu verstehen. Diese Differenz kann ggf. auch negative Werte annehmen, wenn der Intermodulationssignalpegel kleiner ist als der zum Vergleich herangezogene Signalpegel, wenn also ein benachbarter Signalpegel den Intermodulationssignalpegel überragt. Dieser Fall führt in der Regel zu einem unplausiblen Messergebnis.

Enthalten benachbarte Spektralanteile (z. B. im Abstand 1 kHz bis 15 kHz, je nach Mobilfunkstandard) einen erhöhte Signalpegel (d. h. einen erkennbaren Signalpegel über dem Rauschen), so deutet dies auf ein Störsignal im Bereich der Intermodulationsfrequenz hin. Der Pegelabstand der benachbarten Spektralanteile zur Intermodulationsfrequenz kann ausgewertet werden. Ist der Pegelabstand klein (z. B. < 10 dB) wird das Messsignal womöglich bereits verfälscht, mit dem Ergebnis erhöhter Unsicherheit bzw. reduzierter Plausibilität. Ist der Pegelabstand nochmals geringer (z. B. < 3 dB) wird das Intermodulationssignal sehr stark verfälscht oder geht bereits im störenden Rauschen unter - der Messwert an dieser Messfrequenz kann dann nicht eindeutig bestimmt werden und ist somit gegebenenfalls ungültig bzw. nicht plausibel.

Vorzugsweise werden alle weiteren Messfrequenzen in dem diskreten Frequenzspektrum für den Vergleich deren jeweiliger Signalpegel mit dem Intermodulationssignalpegel herangezogen. Auf diese Weise kann ermittelt werden, ob sich innerhalb des untersuchten Messfrequenzbereichs Signalpegel finden, die in ihrer Größenordnung dem Intermodulationssignalpegel nahekommen oder diese gegebenenfalls sogar überragen, was auf eine Störung oder Einkopplung in der Übertragungsstrecke schließen lässt und damit die Plausibilität der Intermodulationsmessung verringern kann.

In einer vorteilhaften Weiterbildung der Erfindung kann vorgesehen sein, dass die Plausibilität der Intermodulationsmessung unzureichend ist, wenn die Differenz zwischen dem Intermodulationssignalpegel und zumindest einem der Signalpegel der für die Plausibilitätskontrolle herangezogenen Messfrequenzen einen definierten Schwellenwert unterschreitet, insbesondere einen Schwellenwert zwischen 3 dB bis 10 dB unterschreitet.

Hebt sich der erfasste Intermodulationssignalpegel deutlich vom umgebenden Rauschen ab, kann die Erfassung der Intermodulationsquelle als plausibel betrachtet werden (beispielsweise ab einer Differenz von 10 dB).

Hebt sich der Intermodulationssignalpegel nur unwesentlich von der benachbarten Leistungsdichte bzw. von den benachbarten Signalpegeln ab, verfälscht das überlagerte Rauschen in der Regel bereits den Messwert und es kann zumindest eine Wiederholung der Intermodulationsmessung angezeigt sein.

Sticht der Intermodulationssignalpegel nicht aus den benachbarten Signalpegeln hervor, wird die Intermodulationsquelle (falls überhaupt vorhanden) vollständig von sonstigen Störungen oder Einkopplungen überdeckt und die Messung kann als nicht aussagekräftig bzw. nicht plausibel gewertet werden.

Die Differenz zwischen dem Intermodulationssignalpegel und zumindest einer der Signalpegel der berücksichtigten, weiteren Messfrequenzen kann vorzugsweise auch zur Berechnung des Plausibilitätskennwerts verwendet werden.

In einer vorteilhaften Weiterbildung der Erfindung kann vorgesehen sein, dass zumindest die Signalpegel der diskreten Messfrequenzen für die Plausibilitätskontrolle herangezogen werden, die im diskreten Frequenzspektrum unmittelbar an die diskrete Intermodulationsfrequenz angrenzen.

Vorzugsweise können also zumindest die Messfrequenzen unmittelbar neben der Intermodulationsfrequenz für die Plausibilitätskontrolle herangezogen werden, gegebenenfalls auch ausschließlich herangezogen werden. Auch eine Reihe von Messfrequenzen, die unmittelbar an die Intermodulationsfrequenz angrenzt (insbesondere beidseitig) kann für die Plausibilitätskontrolle herangezogen werden, beispielsweise beiderseits der Intermodulationsfrequenz jeweils 2 bis 100, 5 bis 50 oder 10 bis 20 benachbarte Messfrequenzen.

Gemäß einer Weiterbildung der Erfindung kann vorgesehen sein, dass für die Plausibilitätskontrolle zunächst aus den Signalpegeln einiger oder aller Messfrequenzen im diskreten Frequenzspektrum ein mittlerer Signalpegel bestimmt und mit dem Intermodulationssignalpegel verglichen wird, wobei die Plausibilität der Intermodulationsmessung mit der Differenz zwischen dem Intermodulationssignalpegel und dem mittleren Signalpegel steigt.

In einer Weiterbildung der Erfindung kann gegebenenfalls auch ein mehrstufiger Analyseansatz bzw. eine mehrstufige Plausibilitätskontrolle vorgesehen sein, wobei innerhalb des Messfrequenzbereichs zunächst ein erstes, grobes Fenster zur Einbeziehung vieler oder aller Messfrequenzen verwendet und im Zweifel anschließend ein zweites, engeres Fenster zur Einbeziehung weniger Messfrequenzen verwendet wird.

Es kann also vorgesehen sein, den Analysebereich um die Intermodulationsfrequenz herum während der Plausibilitätskontrolle zu verkleinern.

In einer Weiterbildung der Erfindung kann vorgesehen sein, dass die Messung des Ausgangssignals mittels eines Software Defined Radios (SDR) durchgeführt wird.

Auf die konkrete Ausgestaltung der Messeinrichtung kommt es grundsätzlich allerdings nicht unbedingt an. Beispielsweise kann auch ein Überlagerungsempfänger bzw. Superheterodynempfänger vorgesehen sein, mit nachgeschaltetem Pegelmesser (logarithmischer Detektor, Analog-Digital-Wandler oder Gleichrichterdiode).

Gemäß einer Weiterbildung der Erfindung kann vorgesehen sein, dass ein diskretes Modell-Frequenzspektrum auf Grundlage eines Modells der Übertragungsstrecke und den eingespeisten Testsignalen berechnet wird, wobei durch Korrelation des diskreten Modell-Frequenzspektrums mit dem diskreten Frequenzspektrum ein Korrelationskoeffizient bestimmt wird. Anhand des Korrelationskoeffizienten kann schließlich die Ähnlichkeit zwischen dem diskreten Modell-Frequenzspektrum und dem diskreten Frequenzspektrum ermittelt werden, um auf die Plausibilität der Intermodulationsmessung zu schließen. Mit steigender Abweichung des gemessenen Frequenzspektrums von dem erwarteten Modell-Frequenzspektrum kann von einer sinkenden Plausibilität der Intermodulationsmessung ausgegangen werden.

Das Modell-Frequenzspektrum kann für eine intermodulationsfreie Übertragungsstrecke und/oder eine Übertragungsstrecke mit einer Modell-Intermodulationsquelle berechnet werden und/oder durch paralleles Einspeisen der Testsignale in einen Referenz-Prüfling (Referenz-DUT) der intermodulationsfreien Übertragungsstrecke bzw. der Modell-Intermodulationsquelle ermittelt werden.

Vorzugsweise wird hierzu das Anregungssignal, insbesondere beide Testsignale, moduliert (mit jeweils unterschiedlichen Frequenzen). Geeignete Modulationsverfahren können alle gängigen Ein- und Zweiseitenband-Modulationsverfahren sein, wie beispielsweise Amplitudenmodulation, Frequenzmodulation, Phasenmodulation, Pulsamplitudenmodulation, Pulsdichtemodulation, Puls-Pausen-Modulation oder Pulsfrequenzmodulation.

Auf vorteilhafte Weise ist es somit möglich, die Messgröße, also den Intermodulationssignalpegel, trotz Störungen oder Einkopplungen, aus dem potentiell gestörten Ausgangssignal herauszukorrelieren.

Die Erfindung betrifft auch ein Computerprogramm, umfassend Steuerbefehle, die bei der Ausführung des Programms durch eine Steuereinrichtung diese veranlassen, das Verfahren gemäß den vorstehenden und nachfolgenden Ausführungen auszuführen.

Die Steuereinrichtung kann als Mikroprozessor ausgebildet sein. Anstelle eines Mikroprozessors kann auch eine beliebige weitere Einrichtung zur Implementierung der Steuereinrichtung vorgesehen sein, beispielsweise eine oder mehrere Anordnungen diskreter elektrischer Bauteile auf einer Leiterplatte, eine speicherprogrammierbare Steuerung (SPS), eine anwendungsspezifische integrierte Schaltung (ASIC) oder eine sonstige programmierbare Schaltung, beispielsweise auch ein Field Programmable Gate Array (FPGA), eine programmierbare logische Anordnung (PLA) und/oder ein handelsüblicher Computer.

Durch das vorgeschlagene Computerprogramm kann auf vorteilhafte Weise eine Erkennung und Bewertung von Störungen während einer Intermodulationsmessung ermöglicht werden. Das eigentliche Messignal zur Ermittlung der Intermodulationsquelle kann dadurch vorteilhaft von Störsignalen unterschieden werden.

Die Erfindung betrifft außerdem auch eine Intermodulations-Messvorrichtung gemäß Anspruch 14.

Durch die vorgeschlagene Intermodulations-Messvorrichtung kann eine Intermodulationsmessung auch bei vorhandenen, überlagerten Störungen durchgeführt werden, optional bei Auswertung der Plausibilität der Messung.

Anstelle einer diskreten bzw. schmalbandigen Intermodulationsmessung um die Intermodulationsfrequenz kann mit der vorgeschlagenen Intermodulations-Messvorrichtung eine breitbandigere Messung durchgeführt werden, so dass zumindest zwei weitere Messfrequenzen im Rahmen einer Spektralanalyse erfasst werden.

Merkmale, die im Zusammenhang mit einem der Gegenstände der Erfindung, namentlich gegeben durch das erfindungsgemäße Intermodulations-Messverfahren, das Computerprogramm oder die Intermodulations-Messvorrichtung beschrieben wurden, sind auch für die anderen Gegenstände der Erfindung vorteilhaft umsetzbar. Ebenso können Vorteile, die im Zusammenhang mit einem der Gegenstände der Erfindung genannt wurden, auch auf die anderen Gegenstände der Erfindung bezogen verstanden werden.

Ergänzend sei darauf hingewiesen, dass Begriffe wie "umfassend", "aufweisend" oder "mit" keine anderen Merkmale oder Schritte ausschließen. Ferner schließen Begriffe wie "ein" oder "das", die auf eine Einzahl von Schritten oder Merkmalen hinweisen, keine Mehrzahl von Merkmalen oder Schritten aus - und umgekehrt.

In einer puristischen Ausführungsform der Erfindung kann allerdings auch vorgesehen sein, dass die in der Erfindung mit den Begriffen "umfassend", "aufweisend" oder "mit" eingeführten Merkmale abschließend aufgezählt sind. Dementsprechend kann eine oder können mehrere Aufzählungen von Merkmalen im Rahmen der Erfindung als abgeschlossen betrachtet werden, beispielsweise jeweils für jeden Anspruch betrachtet. Die Erfindung kann beispielsweise ausschließlich aus den in Anspruch 1 genannten Merkmalen bestehen.

Es sei erwähnt, dass Bezeichnungen wie "erstes" oder "zweites" etc. vornehmlich aus Gründen der Unterscheidbarkeit von jeweiligen Vorrichtungs- oder Verfahrensmerkmalen verwendet werden und nicht unbedingt andeuten sollen, dass sich Merkmale gegenseitig bedingen oder miteinander in Beziehung stehen.

Ferner sei betont, dass die vorliegend beschriebenen Werte und Parameter Abweichungen oder Schwankungen von ±10% oder weniger, vorzugsweise ±5% oder weniger, weiter bevorzugt ±1% oder weniger, und ganz besonders bevorzugt ±0,1% oder weniger des jeweils benannten Wertes bzw. Parameters mit einschließen, sofern diese Abweichungen bei der Umsetzung der Erfindung in der Praxis nicht ausgeschlossen sind. Die Angabe von Bereichen durch Anfangs- und Endwerte umfasst auch all diejenigen Werte und Bruchteile, die von dem jeweils benannten Bereich eingeschlossen sind, insbesondere die Anfangs- und Endwerte und einen jeweiligen Mittelwert.

Nachfolgend werden Ausführungsbeispiele der Erfindung anhand der Zeichnungen näher beschrieben.

Die Figuren zeigen jeweils bevorzugte Ausführungsbeispiele, in denen einzelne Merkmale der vorliegenden Erfindung in Kombination miteinander dargestellt sind. Merkmale eines Ausführungsbeispiels sind auch losgelöst von den anderen Merkmalen des gleichen Ausführungsbeispiels umsetzbar und können dementsprechend von einem Fachmann ohne Weiteres zu weiteren sinnvollen Kombinationen und Unterkombinationen mit Merkmalen anderer Ausführungsbeispiele verbunden werden.

In den Figuren sind funktionsgleiche Elemente mit denselben Bezugszeichen versehen.

Es zeigen schematisch:
- Figur 1: ein Intermodulations-Messverfahren gemäß einem Ausführungsbeispiel der Erfindung;
- Figur 2: eine Intermodulations-Messvorrichtung gemäß einem Ausführungsbeispiel der Erfindung; und
- Figuren 3-8: verschiedene Beispiele eines jeweiligen diskreten Frequenzspektrums im Rahmen der Analyse des Ausgangssignals.

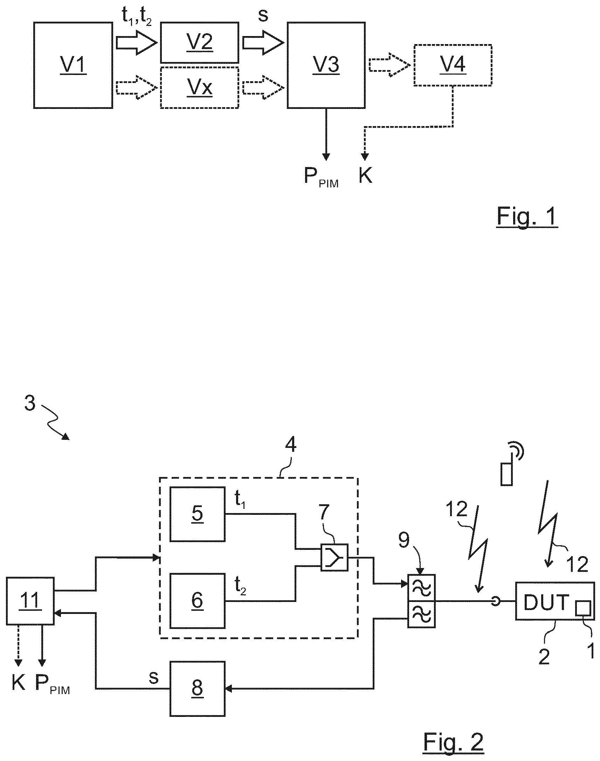

In Figur 1 ist ein Intermodulations-Messverfahren zur Ermittlung einer Intermodulationsquelle 1 mittels Intermodulationsmessung in einer Übertragungsstrecke 2 dargestellt; Figur 2 zeigt eine entsprechende Intermodulations-Messvorrichtung 3. Besonders vorteilhaft eignet sich die Erfindung zur Ermittlung einer passiven Intermodulationsquelle 1 in einer Mobilfunk-Übertragungsstrecke 2. Die zu überprüfende Übertragungsstrecke 2 ("device under test", DUT) kann eine oder mehrere elektronische Komponenten aufweisen, wie beispielsweise Antennen, Steckverbinder (insbesondere HF-Verbinder), Filter, elektrische Leitungen (insbesondere HF-Leitungen), passive Bauelemente, elektrische Lasten oder sonstige Komponenten (in den Figuren nicht dargestellt).

Die nachfolgend beschriebene Verfahrensabfolge des erfindungsgemäßen Intermodulations-Messverfahrens ist lediglich beispielhaft und nicht einschränkend zu verstehen. Insbesondere können Verfahrensschritte mitunter auch vertauscht, kombiniert, ersetzt, gestrichen oder mit weiteren Merkmalen ergänzt werden. Auch optionale, weitere Verfahrensschritte können vorgesehen sein, auch wenn dies nicht explizit angegeben ist.

Gemäß einem ersten Verfahrensschritt V1 des Intermodulations-Messverfahrens wird ein erstes Testsignal t₁ simultan mit einem zweiten Testsignal t₂ in die Übertragungsstrecke 2 eingespeist. Hierzu kann die Intermodulations-Messvorrichtung 3, wie in Figur 2 angedeutet, einen Testsignalgenerator 4 aufweisen mit einer ersten Signalquelle 5 zur Erzeugung des ersten Testsignals t₁ und mit einer zweiten Signalquelle 6 zur Erzeugung des zweiten Testsignals t₂, die beispielsweise mittels eines Combiners 7 zusammengeführt und in Kombination bzw. simultan in die Übertragungsstrecke 2 eingespeist werden.

Bei den Testsignalen t₁, t₂ kann es sich insbesondere um Sinussignale handeln, mit vorzugsweise jeweils konstanter Testsignalfrequenz. Grundsätzlich können die Testsignale t₁, t₂ allerdings auch variierende Testsignalfrequenzen aufweisen, beispielsweise für die nachfolgend noch beschriebene Korrelationsanalyse.

In einem zweiten Verfahrensschritt V2 kann vorgesehen sein, ein Ausgangssignal s der Übertragungsstrecke 2 als Reaktion auf die eingespeisten Testsignale t₁, t₂ mittels einer Messeinrichtung 8 zu messen. Wie in Figur 2 dargestellt, können der Testsignalgenerator 4 und die Messeinrichtung 8 beispielsweise über einen Diplexer 9 gemeinsam mit der Übertragungsstrecke 2 verbunden sein. Die Messung des Ausgangssignals s kann grundsätzlich auf beliebige Weise erfolgen, vorzugsweise mittels eines Software Defined Radios.

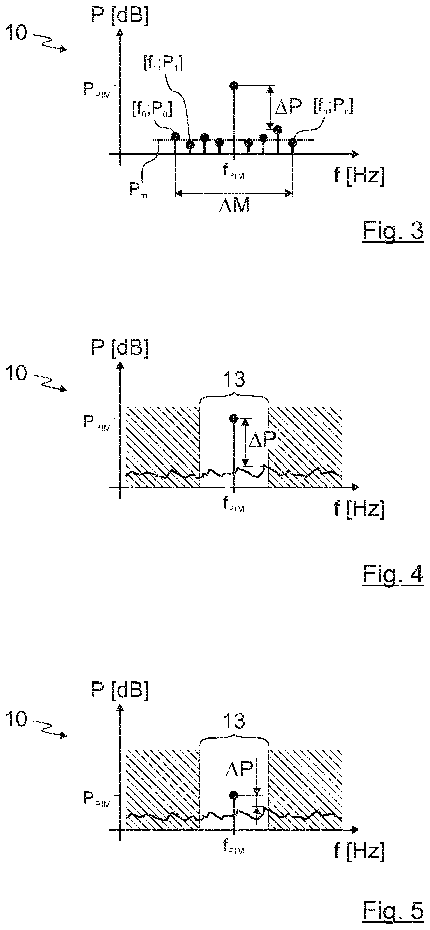

In einem dritten Verfahrensschritt V3 ist vorgesehen, das zuvor gemessene Ausgangssignal s in einem diskreten Frequenzspektrum 10 zu analysieren. Hierzu kann eine Steuereinrichtung 11 vorgesehen sein, wie in Figur 2 angedeutet. Durch die Analyse des diskreten Frequenzspektrums 10 kann ein Intermodulationssignalpegel P_{PIM} einer diskreten Intermodulationsfrequenz f_{PIM} (insbesondere dritter Ordnung) bestimmt werden. Verschiedene beispielhafte diskrete Frequenzspektren 10 im Rahmen einer beispielhaften Analyse eines Ausgangssignals s sind in den Figuren 3 bis 8 schematisch gezeigt.

Das diskrete Frequenzspektrum 10 kann vorzugsweise mittels einer schnellen Fourier-Transformation (FFT) berechnet werden. Die Auflösungsbandbreite des Frequenzspektrums 10 kann beispielsweise 100 Hz bis 10 kHz betragen, vorzugsweise 500 Hz bis 5 kHz, insbesondere 1 kHz.

Es wird vorgeschlagen, den Messfrequenzbereich ΔM des Frequenzspektrums 10 so festzulegen, dass das Frequenzspektrum 10 vorzugsweise zumindest die Signalpegel P_{0...n} zweier weiterer diskreter Messfrequenzen f_{0...n} aufweist, die die Intermodulationsfrequenz f_{PIM} umgeben (exemplarisch in Figur 3 dargestellt).

Die Intermodulationsfrequenz f_{PIM} kann als Mittenfrequenz zwischen den weiteren diskreten Messfrequenzen f_{0...n} in dem diskreten Frequenzspektrum 10 festgelegt werden. In dem Frequenzspektrum 10 der Figur 3 sind neben der Intermodulationsfrequenz f_{PIM} beispielhaft beidseitig jeweils vier weitere Messfrequenzen im Messfrequenzbereich ΔM enthalten, was grundsätzlich aber nur zur Verdeutlichung der Zusammenhänge verstanden werden soll. In den nachfolgenden Figuren 4 bis 8 sind die weiteren Messfrequenzen f_{0...n} vereinfacht und nicht mehr separat mit einzelnen Signalpegeln dargestellt.

Der in dem diskreten Frequenzspektrum 10 analysierte Messfrequenzbereich ΔM wird vorzugsweise auf 10 kHz bis 100 kHz, besonders bevorzugt 40 kHz, festgelegt. Insbesondere kann vorgesehen sein, dass der analysierte Messfrequenzbereich ΔM der Nutzbandbreite eines für die Übertragungsstrecke 2 relevanten Mobilfunkstandards entspricht, so dass alle Mobilfunksignale 12 in dem Frequenzspektrum 10 enthalten sind, um diese von der Intermodulationsfrequenz f_{PIM} unterscheidbar zu machen.

Im Rahmen der Analyse des Frequenzspektrums 10 wird nun vorzugsweise zunächst der Intermodulationssignalpegel P_{PIM} an der vorgesehenen Intermodulationsfrequenz f_{PIM} bestimmt. Optional kann in einem vierten Verfahrensschritt V4 anschließend eine Plausibilitätskontrolle der Intermodulationsmessung durchgeführt werden, um auszuwerten, ob der in dem diskreten Frequenzspektrum 10 erfasste Intermodulationssignalpegel P_{PIM} mit ausreichender Plausibilität auf eine Intermodulationsquelle 1 in der Übertragungsstrecke 2 zurückzuführen ist, anstatt auf eine sonstige Störung oder Einkopplung in der Übertragungsstrecke 2. In Abhängigkeit der Plausibilität kann anschließend die Intermodulationsmessung verworfen, wiederholt oder zur Ermittlung der Intermodulationsquelle 1 herangezogen werden.

Die Plausibilitätskontrolle soll nun beispielhaft und nicht limitierend anhand der Figuren 3 bis 8 erläutert werden.

Für die Plausibilitätskontrolle kann vorgesehen sein, die Signalpegel P_{0...n} zumindest der unmittelbar an die Intermodulationsfrequenz f_{PIM} angrenzenden weiteren Messfrequenzen f_{0...n} im diskreten Frequenzspektrum 10 mit den Intermodulationssignalpegeln P_{PIM} zu vergleichen. Die Plausibilität der Intermodulationsmessung, beispielsweise ein Plausibilitätskennwert K, steigt dabei mit der Differenz ΔP zwischen dem Intermodulationssignalpegel P_{PIM} und dem größten Signalpegel P_{0...n} der für die Plausibilitätskontrolle herangezogenen Messfrequenzen f_{0...n}.

In den Figuren 3 und 4 hebt sich der Intermodulationssignalpegel P_{PIM} der vermeintlichen Intermodulationsquelle 1 deutlich von den Signalpegeln P_{0...n} der weiteren Messfrequenzen f_{0...n} bzw. vom Rauschen ab und kann daher als ausreichend plausibel angesehen werden. Es ist insbesondere in den Figuren 3 und 4 davon auszugehen, dass der erfasste Intermodulationssignalpegel P_{PIM} tatsächlich auf eine Intermodulationsquelle 1 und nicht auf eine Einkopplung, beispielsweise eines Mobilfunksignals 12, zurückzuführen ist.

Hingegen ist die Differenz ΔP zwischen dem Intermodulationssignalpegel P_{PIM} und den umgebenden Signalpegeln P_{0...n} bei dem in Figur 5 dargestellten Beispiel deutlich geringer. Ein Techniker kann daher aufgefordert werden, die Messung zu verwerfen oder zu wiederholen.

Alternativ oder ergänzend zu einer Plausibilitätskontrolle auf Grundlage eines direkten Pegelvergleichs bzw. der Betrachtung benachbarter Maxima kann auch vorgesehen sein, dass im Rahmen der Plausibilitätskontrolle aus den Signalpegeln P_{0...n} einiger oder aller Messfrequenzen f_{0...n} im diskreten Frequenzspektrum 10 zunächst ein mittlerer Signalpegel Pₘ (vgl. Figur 3) bestimmt und mit dem Intermodulationssignalpegel P_{PIM} verglichen wird, wobei die Plausibilität der Intermodulationsmessung mit der Differenz zwischen dem Intermodulationssignalpegel P_{PIM} und dem mittleren Signalpegel steigt Pₘ.

Es kann vorgesehen sein, einen Schwellenwert für die Differenz ΔP zu definieren, bei dessen Unterschreiten (beispielsweise 3 dB bis 10 dB) die Intermodulationsmessung als nicht mehr ausreichend plausibel gekennzeichnet wird.

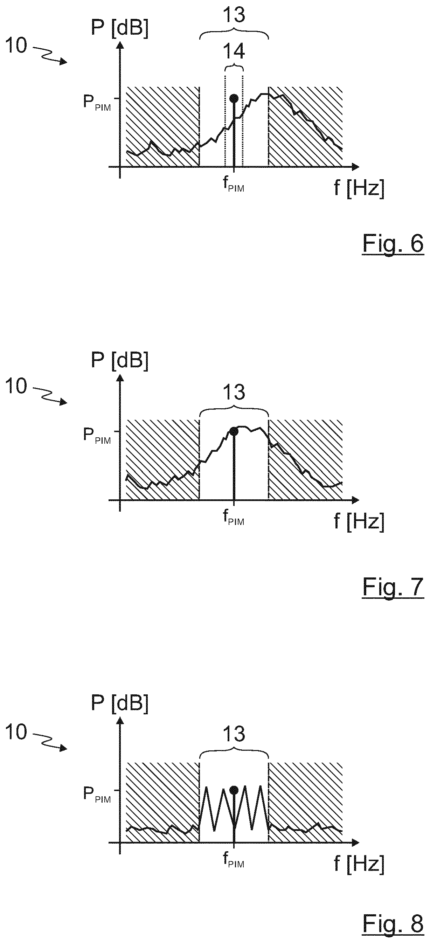

Ein weiteres Beispiel eines diskreten Frequenzspektrums 10 im Rahmen einer Intermodulationsmessung ist in Figur 6 dargestellt. Das dargestellte Frequenzspektrum 10 kann sich beispielsweise bei Einkopplung eines GMSK oder CDMA-Mobilfunksignals 12 ergeben. In diesem Fall kann sich der Intermodulationssignalpegel P_{PIM} an der Intermodulationsfrequenz f_{PIM} von den umgebenden Messfrequenzen f_{0...n} durchaus abheben, was allerdings erst bei näherer Betrachtung um die Intermodulationsfrequenz f_{PIM} herum erkennbar ist. Bei Betrachtung aller Messfrequenzen f_{0...n} im gesamten Messfrequenzbereich ΔM für die Bestimmung der Differenz ΔP ergibt sich hingegen ein Ausschluss der Messung. Es kann daher gegebenenfalls ein mehrstufiger Analyseansatz vorgesehen sein, wobei innerhalb des Messfrequenzbereichs ΔM zunächst ein erstes, gröberes Fenster 13 und im Zweifel später ein zweites, engeres Fenster 14 zur Einbeziehung weniger Messfrequenzen f_{0...n} verwendet wird. Somit kann sich hinsichtlich der in Figur 6 dargestellten Intermodulationsmessung noch eine ausreichende Plausibilität der Messung ergeben, gegebenenfalls aber mit dem Hinweis, die Messung falls möglich zu wiederholen, da offensichtlich eine Einkopplung stattgefunden hat.

Ein ähnlicher Sachverhalt ist in dem Frequenzspektrum 10 der Figur 7 dargestellt, wobei sich an der Intermodulationsfrequenz f_{PIM}, im Gegensatz zu dem vorhergehenden Beispiel, unabhängig vom verwendeten Fenster 13, 14 kein separat erkennbarer Intermodulationssignalpegel P_{PIM} mehr ablesen lässt. Die Intermodulationsmessung gemäß Figur 7 wäre demnach zu verwerfen.

Schließlich zeigt Figur 8 ein weiteres Frequenzspektrum 10 einer Intermodulationsmessung, in die ein Mobilfunksignal 12 mit OFDM-Technik eingekoppelt wurde. Je nach Signalpegel der Intermodulationsfrequenz f_{PIM} kann eine Intermodulationsquelle 1 in diesem Fall in der Regel nicht verlässlich erkannt werden, da nicht ausgeschlossen werden kann, dass der erfasste Intermodulationssignalpegel P_{PIM} an der Intermodulationsfrequenz f_{PIM} nicht einem benachbarten Maximum der Signalpegel P_{0...n} entspricht. In Figur 8 ist der erfasste Signalpegel P_{0...n} vermutlich auf eine Intermodulationsquelle 1 zurückzuführen - aufgrund der Unsicherheit wäre die Intermodulationsmessung allerdings vorsorglich zu wiederholen.

Abschließend sei erwähnt, dass die Plausibilität der Intermodulationsmessung auch dadurch bestimmt werden kann, dass in einem optionalen Verfahrensschritt Vx (vgl. Figur 1) ein diskretes Modell-Frequenzspektrum auf Grundlage eines Modells der Übertragungsstrecke 2 und den eingespeisten Testsignalen t₁, t₂ berechnet wird, wobei die Testsignale t₁, t₂ moduliert werden und durch Korrelation des diskreten Modell-Frequenzspektrums mit dem diskreten Frequenzspektrums 10 des Ausgangssignals s zunächst ein Korrelationskoeffizient bestimmt wird. Anhand des Korrelationskoeffizienten kann schließlich die Ähnlichkeit zwischen dem diskreten Modell-Frequenzspektrum und dem diskreten Frequenzspektrum ermittelt werden, um auf die Plausibilität der Intermodulationsmessung zu schließen.

Auf ähnliche Weise kann eine Korrelation auch im Zeitbereich erfolgen, um die Ermittlung der Intermodulationsquelle 1 zu ermöglichen, gemäß einem alternativen Intermodulations-Messverfahren bzw. einer alternativen Intermodulations-Messvorrichtung, wobei eine Spektralanalyse für diesen Fall nicht unbedingt erforderlich ist.

Es kann ein Computerprogramm vorgesehen sein, umfassend Steuerbefehle, die bei der Ausführung des Programms durch eine Steuereinrichtung, beispielsweise die Steuereinrichtung 11 der Intermodulations-Messvorrichtung 3, die Steuereinrichtung veranlassen, das vorstehend und nachstehend beschriebene Verfahren auszuführen.

## Patentansprüche

1. Intermodulations-Messverfahren zur Ermittlung einer Intermodulationsquelle (1) mittels Intermodulationsmessung in einer Übertragungsstrecke (2), insbesondere zur Ermittlung einer passiven Intermodulationsquelle in einer Mobilfunk-Übertragungsstrecke, aufweisend zumindest die folgenden Verfahrensschritte:
- Simultanes Einspeisen eines ersten Testsignals (t₁) und eines zweiten Testsignals (t₂) in die Übertragungsstrecke (2); und
- Messen eines Ausgangssignals (s) der Übertragungsstrecke (2) als Reaktion auf die eingespeisten Testsignale (t₁, t₂),
wobei das Ausgangssignal (s) in einem diskreten Frequenzspektrum (10) analysiert wird, um den Intermodulationssignalpegel (P_{PIM}) an einer diskreten Intermodulationsfrequenz (f_{PIM}) zu bestimmen, wobei der Messfrequenzbereich (ΔM) des Frequenzspektrums (10) so festgelegt wird, dass das Frequenzspektrum (10) zumindest den Signalpegel (P_{0...n}) einer weiteren diskreten Messfrequenz (f_{0...n}) aufweist,
**dadurch gekennzeichnet , dass**
mittels einer Steuereinrichtung (11) eine Plausibilitätskontrolle der Intermodulationsmessung durchgeführt wird um auszuwerten, ob der in dem diskreten Frequenzspektrum (10) erfasste Intermodulationssignalpegel (P_{PIM}) mit ausreichender Plausibilität auf eine Intermodulationsquelle (1) in der Übertragungsstrecke (2) zurückzuführen ist anstatt auf eine sonstige Störung oder Einkopplung in der Übertragungsstrecke (2), wobei die Intermodulationsmessung in Abhängigkeit der Plausibilität, vorzugsweise in Abhängigkeit eines von der Steuereinrichtung (11) bestimmten Plausibilitätskennwerts (K), verworfen, wiederholt oder zur Ermittlung der Intermodulationsquelle (1) herangezogen wird.

2. Intermodulations-Messverfahren nach Anspruch 1,
**dadurch gekennzeichnet , dass**
die Auflösungsbandbreite des diskreten Frequenzspektrum (10) 100 Hz bis 10 kHz beträgt, vorzugsweise 500 Hz bis 5 kHz, besonders bevorzugt 1 kHz.

3. Intermodulations-Messverfahren nach Anspruch 1 oder 2,
**dadurch gekennzeichnet , dass**
der in dem diskreten Frequenzspektrum (10) analysierte Messfrequenzbereich (ΔM) 10 kHz bis 100 kHz beträgt, vorzugsweise 20 kHz bis 80 kHz, besonders bevorzugt 30 kHz bis 50 kHz, ganz besonders bevorzugt 40 kHz, und insbesondere wenigstens einen Trägerfrequenzabstand eines Mobilfunkstandards umfasst.

4. Intermodulations-Messverfahren nach einem der Ansprüche 1 bis 3,
**dadurch gekennzeichnet , dass**
der Intermodulationssignalpegel (P_{PIM}) der Intermodulationsfrequenz (f_{PIM}) dritter Ordnung bestimmt wird, insbesondere durch Subtraktion der Testsignalfrequenz des zweiten Testsignals (t₂) von der doppelten Testsignalfrequenz des ersten Testsignals (t₁).

5. Intermodulations-Messverfahren nach einem der Ansprüche 1 bis 4,
**dadurch gekennzeichnet , dass**
die diskrete Intermodulationsfrequenz (f_{PIM}) die Mittenfrequenz zwischen den weiteren diskreten Messfrequenzen (f_{0...n}) in dem diskreten Frequenzspektrum (10) bildet.

6. Intermodulations-Messverfahren nach einem der Ansprüche 1 bis 5,
**dadurch gekennzeichnet , dass**
für die Plausibilitätskontrolle die Signalpegel (P_{0...n}) einiger oder aller Messfrequenzen (f_{0...n}) im diskreten Frequenzspektrum (10) mit dem Intermodulationssignalpegel (P_{PIM}) verglichen werden, wobei die Plausibilität der Intermodulationsmessung mit der Differenz (ΔP) zwischen dem Intermodulationssignalpegel (P_{PIM}) und dem größten Signalpegel (P_{0...n}) der für die Plausibilitätskontrolle herangezogenen Messfrequenzen (f_{0...n}) steigt.

7. Intermodulations-Messverfahren nach Anspruch 6,
**dadurch gekennzeichnet , dass**
für die Plausibilitätskontrolle eine iterative Analyse vorgesehen ist, bei der zunächst ein erstes, grober Fenster (13) zur Einbeziehung der Signalpegel (P_{0...n}) einiger oder aller Messfrequenzen (f_{0...n}) im diskreten Frequenzspektrum (10) für den Vergleich mit dem Intermodulationssignalpegel (P_{PIM}) herangezogen werden, und anschließend zumindest ein zweites, engeres Fenster (14) zur Einbeziehung einer Untermenge der im ersten Fenster (13) berücksichtigten Messfrequenzen (f_{0...n}) vorgesehen ist.

8. Intermodulations-Messverfahren nach Anspruch 6 oder 7,
**dadurch gekennzeichnet , dass**
die Plausibilität der Intermodulationsmessung unzureichend ist, wenn die Differenz (ΔP) zwischen dem Intermodulationssignalpegel (P_{PIM}) und zumindest einem der Signalpegel (P_{0...n}) der für die Plausibilitätskontrolle herangezogenen Messfrequenzen (f_{0...n}) einen definierten Schwellenwert unterschreitet, insbesondere einen Schwellenwert zwischen 3 dB bis 10 dB unterschreitet.

9. Intermodulations-Messverfahren nach einem der Ansprüche 1 bis 8,
**dadurch gekennzeichnet , dass**
zumindest die Signalpegel (P_{0...n}) der diskreten Messfrequenzen (f_{0...n}) für die Plausibilitätskontrolle herangezogen werden, die im diskreten Frequenzspektrum (10) unmittelbar an die diskrete Intermodulationsfrequenz (f_{PIM}) angrenzen.

10. Intermodulations-Messverfahren nach einem der Ansprüche 1 bis 9,
**dadurch gekennzeichnet , dass**
für die Plausibilitätskontrolle zunächst aus den Signalpegeln (P_{0...n}) einiger oder aller Messfrequenzen (f_{0...n}) im diskreten Frequenzspektrum (10) ein mittlerer Signalpegel (Pₘ) bestimmt und mit dem Intermodulationssignalpegel (P_{PIM}) verglichen wird, wobei die Plausibilität der Intermodulationsmessung mit der Differenz (ΔP) zwischen dem Intermodulationssignalpegel (P_{PIM}) und dem mittleren Signalpegel (Pₘ) steigt.

11. Intermodulations-Messverfahren nach einem der Ansprüche 1 bis 10,
**dadurch gekennzeichnet , dass**
die Messung des Ausgangssignals (s) mittels eines Software Defined Radios durchgeführt wird.

12. Intermodulations-Messverfahren nach einem der Ansprüche 1 bis 11,
**dadurch gekennzeichnet , dass**
ein diskretes Modell-Frequenzspektrum auf Grundlage eines Modells der Übertragungsstrecke (2) und den eingespeisten Testsignalen (t₁, t₂) berechnet wird, wobei durch Korrelation des diskreten Modell-Frequenzspektrums mit dem diskreten Frequenzspektrum (10) ein Korrelationskoeffizient bestimmt wird, um aufgrund des Korrelationskoeffizienten die Ähnlichkeit zwischen dem diskreten Modell-Frequenzspektrum und dem diskreten Frequenzspektrum (10) zu ermitteln, um auf die Plausibilität der Intermodulationsmessung zu schließen.

13. Computerprogramm, umfassend Steuerbefehle, die bei der Ausführung des Programms durch eine Steuereinrichtung (11) diese veranlassen, das Verfahren gemäß einem der Ansprüche 1 bis 12 auszuführen.

14. Intermodulations-Messvorrichtung (3) zur Ermittlung einer Intermodulationsquelle (1) mittels Intermodulationsmessung in einer Übertragungsstrecke (2), insbesondere zur Ermittlung einer passiven Intermodulationsquelle in einer Mobilfunk-Übertragungsstrecke, aufweisend einen Testsignalgenerator (4) mit einer ersten Signalquelle (5) zum Erzeugen eines ersten Testsignals (t₁) und mit einer zweiten Signalquelle (6) zum Erzeugen eines zweiten Testsignals (t₂), wobei der Testsignalgenerator (4) eingerichtet ist, die Testsignale (t₁, t₂) simultan in die Übertragungsstrecke (2) einzuspeisen, weiter aufweisend eine Messeinrichtung (8) zur Messung eines Ausgangssignals (s) der Übertragungsstrecke (2) als Reaktion auf die eingespeisten Testsignale (t₁, t₂), weiter aufweisend eine Steuereinrichtung (11) die eingerichtet ist, das Ausgangssignal (s) in einem diskreten Frequenzspektrum (10) zu analysieren, um den Intermodulationssignalpegel (P_{PIM}) einer diskreten Intermodulationsfrequenz (f_{PIM}) zu bestimmen, wobei der Messfrequenzbereich (ΔM) des Frequenzspektrums (10) so festgelegt ist, dass das Frequenzspektrum (10) zumindest die Signalpegel (P_{0...n}) zweier diskreter Messfrequenzen (f_{0...n}) aufweist, die die Intermodulationsfrequenz (f_{PIM}) umgeben,
**dadurch gekennzeichnet , dass**
die Steuereinrichtung (11) weiter eingerichtet ist, eine Plausibilitätskontrolle der Intermodulationsmessung durchzuführen um auszuwerten, ob der in dem diskreten Frequenzspektrum (10) erfasste Intermodulationssignalpegel (P_{PIM}) mit ausreichender Plausibilität auf eine Intermodulationsquelle (1) in der Übertragungsstrecke (2) zurückzuführen ist anstatt auf eine sonstige Störung oder Einkopplung in der Übertragungsstrecke (2), wobei die Intermodulationsmessung in Abhängigkeit der Plausibilität, vorzugsweise in Abhängigkeit eines von der Steuereinrichtung (11) bestimmten Plausibilitätskennwerts (K), verworfen, wiederholt oder zur Ermittlung der Intermodulationsquelle (1) herangezogen wird.

## Claims

1. Intermodulation measurement method for ascertaining an intermodulation source (1) by means of intermodulation measurement in a transmission link (2), in particular for ascertaining a passive intermodulation source in a mobile radio transmission link, having at least the following method steps:
- simultaneously supplying a first test signal (t₁) and a second test signal (t₂) to the transmission link (2); and
- measuring an output signal (s) from the transmission link (2) in response to the supplied test signals (t₁, t₂),
wherein the output signal (s) is analyzed in a discrete frequency spectrum (10) in order to determine the intermodulation signal level (P_{PIM}) at a discrete intermodulation frequency (f_{PIM}), the measurement frequency range (ΔM) of the frequency spectrum (10) being stipulated such that the frequency spectrum (10) has at least the signal level (P_{0...n}) associated with a further discrete measurement frequency (f_{0...n}),
**characterized in that**
a control device (11) is used to perform a plausibility check on the intermodulation measurement in order to evaluate whether the intermodulation signal level (P_{PIM}) recorded in the discrete frequency spectrum (10) can be attributed with sufficient plausibility to an intermodulation source (1) in the transmission link (2) rather than to other interference or injected input in the transmission link (2), the intermodulation measurement being rejected, repeated or used to ascertain the intermodulation source (1) on the basis of the plausibility, preferably on the basis of a plausibility characteristic value (K) determined by the control device (11).

2. Intermodulation measurement method according to Claim 1,
**characterized in that**
the resolution bandwidth of the discrete frequency spectrum (10) is 100 Hz to 10 kHz, preferably 500 Hz to 5 kHz, particularly preferably 1 kHz.

3. Intermodulation measurement method according to Claim 1 or 2,
**characterized in that**
the measurement frequency range (ΔM) analyzed in the discrete frequency spectrum (10) is 10 kHz to 100 kHz, preferably 20 kHz to 80 kHz, particularly preferably 30 kHz to 50 kHz, quite particularly preferably 40 kHz, and in particular comprises at least one carrier frequency spacing from a mobile radio standard.

4. Intermodulation measurement method according to one of Claims 1 to 3,
**characterized in that**
the intermodulation signal level (P_{PIM}) associated with the third-order intermodulation frequency (f_{PIM}) is determined, in particular by subtracting the test signal frequency of the second test signal (t₂) from twice the test signal frequency of the first test signal (t₁).

5. Intermodulation measurement method according to one of Claims 1 to 4,
**characterized in that**
the discrete intermodulation frequency (f_{PIM}) forms the center frequency between the further discrete measurement frequencies (f_{0...n}) in the discrete frequency spectrum (10).

6. Intermodulation measurement method according to according to one of Claims 1 to 5,
**characterized in that**
the plausibility check involves the signal levels (P_{0...n}) associated with some or all measurement frequencies (f_{0...n}) in the discrete frequency spectrum (10) being compared with the intermodulation signal level (P_{PIM}), the plausibility of the intermodulation measurement rising with the difference (ΔP) between the intermodulation signal level (P_{PIM}) and the highest signal level (P_{0...n}) associated with the measurement frequencies (f_{0...n}) used for the plausibility check.

7. Intermodulation measurement method according to Claim 6,
**characterized in that**
the plausibility check involves there being provision for an iterative analysis, in which initially a first, coarse window (13) is used to include the signal levels (P_{0...n}) associated with some or all measurement frequencies (f_{0...n}) in the discrete frequency spectrum (10) for the comparison with the intermodulation signal level (P_{PIM}), and there is then provision for at least one second, narrower window (14) for including a subset of the measurement frequencies (f_{0...n}) taken into account in the first window (13).

8. Intermodulation measurement method according to Claim 6 or 7,
**characterized in that**
the plausibility of the intermodulation measurement is insufficient if the difference (ΔP) between the intermodulation signal level (P_{PIM}) and at least one of the signal levels (P_{0...n}) associated with the measurement frequencies (f_{0...n}) used for the plausibility check falls short of a defined threshold value, in particular falls short of a threshold value between 3 dB and 10 dB.

9. Intermodulation measurement method according to one of Claims 1 to 8,
**characterized in that**
at least the signal levels (P_{0...n}) associated with the discrete measurement frequencies (f_{0...n}) that are directly adjacent to the discrete intermodulation frequency (f_{PIM}) in the discrete frequency spectrum (10) are used for the plausibility check.

10. Intermodulation measurement method according to one of Claims 1 to 9,
**characterized in that**
the plausibility check involves the signal levels (P_{0...n}) associated with some or all measurement frequencies (f_{0...n}) in the discrete frequency spectrum (10) initially being used to determine an average signal level (Pₘ), and said average signal level being compared with the intermodulation signal level (P_{PIM}), the plausibility of the intermodulation measurement rising with the difference (ΔP) between the intermodulation signal level (P_{PIM}) and the average signal level (Pₘ).

11. Intermodulation measurement method according to one of Claims 1 to 10,
**characterized in that**
the output signal (s) is measured by means of a software defined radio.

12. Intermodulation measurement method according to one of Claims 1 to 11,
**characterized in that**
a discrete model frequency spectrum is calculated on the basis of a model of the transmission link (2) and the supplied test signals (t₁, t₂), correlation of the discrete model frequency spectrum with the discrete frequency spectrum (10) being used to determine a correlation coefficient in order to take the correlation coefficient as a basis for ascertaining the similarity between the discrete model frequency spectrum and the discrete frequency spectrum (10), in order to infer the plausibility of the intermodulation measurement.

13. Computer program, comprising control commands that, when the program is executed by a control device (11), cause the latter to carry out the method according to one of Claims 1 to 12.

14. Intermodulation measuring apparatus (3) for ascertaining an intermodulation source (1) by means of intermodulation measurement in a transmission link (2), in particular for ascertaining a passive intermodulation source in a mobile radio transmission link, comprising a test signal generator (4) having a first signal source (5) for generating a first test signal (t₁) and having a second signal source (6) for generating a second test signal (t₂), the test signal generator (4) being configured to supply the test signals (t₁, t₂) to the transmission link (2) simultaneously, further comprising a measuring device (8) for measuring an output signal (s) from the transmission link (2) in response to the supplied test signals (t₁, t₂), further comprising a control device (11) that is configured to analyze the output signal (s) in a discrete frequency spectrum (10) in order to determine the intermodulation signal level (P_{PIM}) associated with a discrete intermodulation frequency (f_{PIM}), the measurement frequency range (ΔM) of the frequency spectrum (10) being stipulated such that the frequency spectrum (10) has at least the signal levels (P_{0...n}) associated with two discrete measurement frequencies (f_{0...n}) that surround the intermodulation frequency (f_{PIM}),
**characterized in that**
the control device (11) is further configured to perform a plausibility check on the intermodulation measurement in order to evaluate whether the intermodulation signal level (P_{PIM}) recorded in the discrete frequency spectrum (10) can be attributed with sufficient plausibility to an intermodulation source (1) in the transmission link (2) rather than to other interference or injected input in the transmission link (2), the intermodulation measurement being rejected, repeated or used to ascertain the intermodulation source (1) on the basis of the plausibility, preferably on the basis of a plausibility characteristic value (K) determined by the control device (11).

## Revendications

1. Procédé de mesure d'intermodulation pour déterminer une source d'intermodulation (1) au moyen d'une mesure d'intermodulation dans une ligne de transmission (2), en particulier pour déterminer une source d'intermodulation passive dans une ligne de transmission de radiocommunication mobile, comprenant au moins les étapes consistant à :
- injecter simultanément un premier signal de test (t₁) et un deuxième signal de test (t₂) dans la ligne de transmission (2) ; et
- mesurer un signal de sortie (s) de la ligne de transmission (2) en réaction aux signaux de test injectés (t₁, t₂),
le signal de sortie (s) étant analysé dans un spectre de fréquences discret (10) afin de déterminer le niveau du signal d'intermodulation (P_{PIM}) à une fréquence d'intermodulation discrète (f_{PIM}), la plage de fréquences de mesure (ΔM) du spectre de fréquences (10) étant définie de telle sorte que le spectre de fréquences (10) présente au moins le niveau de signal (P_{0..n}) d'une autre fréquence de mesure discrète (f_{0..n}),
**caractérisé en ce qu'**un contrôle de plausibilité de la mesure d'intermodulation est effectué au moyen d'un dispositif de commande (11) afin d'évaluer si le niveau de signal d'intermodulation (P_{PIM}) détecté dans le spectre de fréquences discret (10) peut être attribué avec une plausibilité suffisante à une source d'intermodulation (1) dans la ligne de transmission (2) plutôt qu'à une autre perturbation ou à un couplage dans la ligne de transmission (2), la mesure d'intermodulation étant rejetée, répétée ou utilisée pour déterminer la source d'intermodulation (1) en fonction de la plausibilité, de préférence en fonction d'un coefficient de plausibilité (K) déterminé par le dispositif de commande (11), est rejetée, répétée ou utilisée pour déterminer la source d'intermodulation (1).

2. Procédé de mesure d'intermodulation selon la revendication 1, **caractérisé en ce que** la largeur de bande de résolution du spectre de fréquences discret (10) est comprise entre 100 Hz et 10 kHz, de préférence entre 500 Hz et 5 kHz, et de manière particulièrement préférée de 1 kHz.

3. Procédé de mesure d'intermodulation selon la revendication 1 ou 2, **caractérisé en ce que** la plage de fréquences de mesure (ΔM) analysée dans le spectre de fréquences discret (10) est comprise entre 10 kHz et 100 kHz, de préférence entre 20 kHz et 80 kHz, de manière particulièrement préférée entre 30 kHz et 50 kHz, de manière très particulièrement préférée de 40 kHz, et comprend en particulier au moins un écart de fréquence porteuse d'une norme de téléphonie mobile.

4. Procédé de mesure d'intermodulation selon l'une des revendications 1 à 3, **caractérisé en ce que** le niveau du signal d'intermodulation (P_{PIM}) de la fréquence d'intermodulation (f_{PIM}) du troisième ordre est déterminé, en particulier par soustraction de la fréquence de signal de test du deuxième signal de test (t₂) de la double fréquence de signal de test du premier signal de test (t₁).

5. Procédé de mesure d'intermodulation selon l'une des revendications 1 à 4, **caractérisé en ce que** la fréquence d'intermodulation discrète (f_{PIM}) forme la fréquence centrale entre les autres fréquences de mesure discrètes (f_{0..n}) dans le spectre de fréquences discret (10).

6. Procédé de mesure d'intermodulation selon l'une des revendications 1 à 5, **caractérisé en ce que**, pour le contrôle de plausibilité, les niveaux de signal (P_{0..n}) de certaines ou de toutes les fréquences de mesure (f_{0..n}) dans le spectre de fréquences discret (10) sont comparés au niveau de signal d'intermodulation (P_{PIM}), la plausibilité de la mesure d'intermodulation augmentant avec la différence (ΔP) entre le niveau du signal d'intermodulation (P_{PIM}) et le niveau de signal le plus élevé (P_{0..n}) des fréquences de mesure (f_{0..n}) utilisées pour le contrôle de plausibilité.

7. Procédé de mesure d'intermodulation selon la revendication 6, **caractérisé en ce que** qu'une analyse itérative est prévue pour le contrôle de plausibilité, dans laquelle une première fenêtre approximative (13) est d'abord utilisée pour inclure les niveaux de signal (P_{0..n}) de certaines ou de toutes les fréquences de mesure (f_{0..n}) dans le spectre de fréquences discret (10) pour la comparaison avec le niveau du signal d'intermodulation (P_{PIM}), puis au moins une deuxième fenêtre plus étroite (14) est utilisée pour inclure un sous-ensemble des fréquences de mesure (f_{0..n}) prises en compte dans la première fenêtre (13).

8. Procédé de mesure d'intermodulation selon la revendication 6 ou 7, **caractérisé en ce que** la plausibilité de la mesure d'intermodulation est insuffisante lorsque la différence (ΔP) entre le niveau du signal d'intermodulation (P_{PIM}) et au moins l'un des niveaux de signal (P_{0..n}) des fréquences de mesure (f_{0..n}) utilisées pour le contrôle de plausibilité soit inférieure à une valeur de seuil définie, en particulier inférieure à une valeur de seuil comprise entre 3 dB et 10 dB.

9. Procédé de mesure d'intermodulation selon l'une des revendications 1 à 8, **caractérisé en ce que** on utilise pour le contrôle de plausibilité au moins les niveaux de signal (P_{0..n}) des fréquences de mesure discrètes (f_{0..n}) qui, dans le spectre de fréquences discret (10), sont immédiatement adjacentes à la fréquence d'intermodulation discrète (f_{PIM}).

10. Procédé de mesure d'intermodulation selon l'une des revendications 1 à 9, **caractérisé en ce que**, pour le contrôle de plausibilité, on détermine d'abord un niveau de signal moyen (Pₘ) à partir des niveaux de signal (P_{0..n}) de certaines ou de toutes les fréquences de mesure (f_{0..n}) dans le spectre de fréquences discret (10) et on le compare au niveau de signal d'intermodulation (P_{PIM}), la plausibilité de la mesure d'intermodulation augmentant avec la différence (ΔP) entre le niveau du signal d'intermodulation (P_{PIM}) et le niveau moyen du signal (Pₘ).

11. Procédé de mesure d'intermodulation selon l'une des revendications 1 à 10, **caractérisé en ce que** la mesure du signal de sortie (s) est effectuée à l'aide d'une radio définie par logiciel.

12. Procédé de mesure d'intermodulation selon l'une des revendications 1 à 11, **caractérisé en ce qu'**un spectre de fréquences discret modèle est calculé sur la base d'un modèle de la ligne de transmission (2) et des signaux de test injectés (t₁, t₂), un coefficient de corrélation étant déterminé par corrélation du spectre de fréquences discret modèle avec le spectre de fréquences discret (10) afin de déterminer, sur la base du coefficient de corrélation, la similitude entre le spectre de fréquences discret modèle et le spectre de fréquences discret (10) afin de conclure à la plausibilité de la mesure d'intermodulation.

13. Programme informatique comprenant des instructions de commande qui, lors de l'exécution du programme par un dispositif de commande (11), amènent celui-ci à exécuter le procédé selon l'une des revendications 1 à 12.

14. Dispositif de mesure d'intermodulation (3) pour déterminer une source d'intermodulation (1) au moyen d'une mesure d'intermodulation dans une ligne de transmission (2), en particulier pour déterminer une source d'intermodulation passive dans une ligne de transmission de radiocommunication mobile, comprenant un générateur de signaux de test (4) avec une première source de signaux (5) pour générer un premier signal de test (t₁) et avec une deuxième source de signaux (6) pour générer un deuxième signal de test (t₂), le générateur de signaux de test (4) étant conçu pour injecter simultanément les signaux de test (t₁, t₂) dans la ligne de transmission (2), comprenant en outre un dispositif de mesure (8) pour mesurer un signal de sortie (s) de la ligne de transmission (2) en réaction aux signaux de test injectés (t₁, t₂) comprenant en outre un dispositif de commande (11) qui est conçu pour analyser le signal de sortie (s) dans un spectre de fréquences discret (10) afin de déterminer le niveau de signal d'intermodulation (P_{PIM}) d'une fréquence d'intermodulation discrète (f_{PIM}), la plage de fréquences de mesure (ΔM) du spectre de fréquences (10) étant définie de telle sorte que le spectre de fréquences (10) présente au moins les niveaux de signal (P_{0..n}) de deux fréquences de mesure discrètes (f_{0..n}) qui entourent la fréquence d'intermodulation (f_{PIM}),
**caractérisé en ce que** le dispositif de commande (11) est en outre conçu pour effectuer un contrôle de plausibilité de la mesure d'intermodulation afin d'évaluer si le niveau de signal d'intermodulation (P_{PIM}) détecté dans le spectre de fréquences discret (10) peut être attribué avec une plausibilité suffisante à une source d'intermodulation (1) dans la ligne de transmission (2) plutôt qu'à une autre perturbation ou à un couplage dans la ligne de transmission (2), la mesure d'intermodulation étant rejetée, répétée ou utilisée pour déterminer la source d'intermodulation (1) en fonction de la plausibilité, de préférence en fonction d'un coefficient de plausibilité (K) déterminé par le dispositif de commande (11), est rejetée, répétée ou utilisée pour déterminer la source d'intermodulation (1).
